(19) Europäisches Patentamt
European Patent Office
Office européen des brevets

(11) **EP 2 405 581 B1**

(12) **EUROPEAN PATENT SPECIFICATION**

(45) Date of publication and mention
of the grant of the patent:
**11.07.2018 Bulletin 2018/28**

(51) Int Cl.:
**H03M 13/11** *(2006.01)*

(21) Application number: **11163739.3**

(22) Date of filing: **11.05.2005**

(54) **Code construction for irregular shortened LDPC codes with good performance**

Codekonstruktion für irreguläre verkürzte LDPC-Codes mit guter Leistungsfähigkeit

Procédé de construction de codes pour codes LDPC raccourcis irréguliers de bonne performance

(84) Designated Contracting States:
**AT BE BG CH CY CZ DE DK EE ES FI FR GB GR HU IE IS IT LI LT LU MC NL PL PT RO SE SI SK TR**

(30) Priority: **14.05.2004 US 571280 P**
**23.06.2004 US 874611**

(43) Date of publication of application:
**11.01.2012 Bulletin 2012/02**

(62) Document number(s) of the earlier application(s) in
accordance with Art. 76 EPC:
**05747940.4 / 1 747 613**

(73) Proprietor: **Google Technology Holdings LLC**
**Mountain View, CA 94043 (US)**

(72) Inventors:
• **Blankenship, Yufei**
**Streamwood, IL 60107 (US)**
• **Classon, Brian K.**
**Palatine, IL 60067 (US)**

(74) Representative: **Openshaw & Co.**
**8 Castle Street**
**Farnham, Surrey GU9 7HR (GB)**

(56) References cited:
• **LI Y ET AL: "Design of Efficiently Encodable Moderate-Length High-Rate Irregular LDPC Codes", IEEE TRANSACTIONS ON COMMUNICATIONS, IEEE SERVICE CENTER, PISCATAWAY, NJ, US, vol. 52, no. 4, 1 April 2004 (2004-04-01), pages 564-571, XP011111852, ISSN: 0090-6778**
• **LI PING ET AL: "Low density parity check codes with semi-random parity check matrix", ELECTRONICS LETTERS, IEE STEVENAGE, GB, vol. 35, no. 1, 7 January 1999 (1999-01-07), pages 38-39, XP002143043, ISSN: 0013-5194**
• **YANG M ET AL: "Performance of effifiently encodable low-density parity-check codes in noise bursts on the EPR4 channel", IEEE TRANSACTIONS ON MAGNETICS, IEEE SERVICE CENTER, NEW YORK, NY, US, vol. 40, no. 2, 1 March 2004 (2004-03-01), pages 507-512, XP002339008, ISSN: 0018-9464**
• **TIFFANY JING LI, RUIYUAN HU: "Robust Distributed Source Encoding Using LDPC Codes", , March 2004 (2004-03), page 1, XP002506615, Lehigh Universitya Retrieved from the Internet: URL:http://www.lehigh.edu/optics/Documents /2004OpenHouse/Posters/4_Li_DSC_LDPC.pdf [retrieved on 2008-12-02]**

**Description**

Field of the Invention

The present invention relates generally to encoding and decoding data and in particular, to a method and apparatus for encoding and decoding data utilizing low-density parity-check (LDPC) codes.

Background of the Invention

A low-density parity-check (LDPC) code is defined by a parity check matrix **H**, which is a low-density pseudorandom binary matrix. For implementation reasons, a single **H** matrix is sometimes preferred even though multiple code rates and block sizes must be supported. In this case, the multiple code rates and block sizes may be obtained by shortening a systematic LDPC code.

In a systematic code that maps k information bits to n coded bits, the first k bits of the coded bits are the information bits. When shortening, L of the information bits are set to zero and the corresponding zeros are removed from the coded bits. Shortening is typically performed by (logically or physically) setting the first L information bits to zero. In some encoders, leading zeros do not change the state of the encoder, so that the zeros do not have to be fed into the encoding circuit. For an LDPC code, shortening by setting the first L information bits to zero can be accomplished in two equivalent ways. First, a k bit information vector can be set with L bits as zero, which is assumed to be located in the first L information bit positions in the following without losing generality. The length k information vector can be fed into the encoder (which may be based on the un-shortened (n-k)-by-n **H** matrix or the equivalent k-by-n generator matrix **G**), and the L zeros subsequently stripped from the coded bits after encoding. Second, a shortened information vector may be passed to the encoder which encodes based on a shortened (n-k)-by-(n-L) **H** matrix with the first L columns removed, or the equivalent shortened (k-L)-by-(n-L) **G** matrix. However, the resulting shortened LDPC code(s) are likely to have poor performance because their weight distribution may be inferior to a code custom designed for that code rate and block size. It is not clear how to construct a shortened LDPC code that maintains good performance.

The digital video broadcasting satellite standard (DVB-S2) uses LDPC codes, and defines an **H** matrix for each desired code rate. DVB-S2 defines ten different LDPC code rates, 1/4, 1/3, 1/2, 3/5, 2/3, 3/4, 4/5, 5/6, 8/9 and 9/10, all with a coded block length *n* = 64 800 bits. For each code rate, a different parity check matrix **H** is specified - shortening is not used in the standard. As is known in the art, irregular LDPC codes offer better performance than the regular LDPC codes. The term regular when used for an LDPC code means that all rows of **H** have the same number of 1's, and all the columns of **H** have a same number of 1's, where the number of 1's in a row or column is also called the weight of the row or column. Otherwise the LDPC code is considered irregular. In a narrower sense, the term regular can also be applied to either the rows or the columns (i.e., a matrix may have regular column weights, but irregular row weights), and can also be applied to a sub-matrix of a matrix (e.g., a sub-matrix of a matrix is regular when all the columns of the sub-matrix have the same column weight and all the rows of the sub-matrix have the same row weight). Because irregular codes are desired for good performance, DVB-S2 defines multiple **H** matrices, each with the desired weight distribution for good performance at that code rate. The numbers of columns of each weight are shown in Table 1 for all the DVB-S2 code rates.

**Table 1. Number of Columns of Various Weights in DVB.**

| Code Rate | 13 | 12 | 11 | 8 | 4 | 3 | 2 | 1 |
|:---:|:---:|:---:|:---:|:---:|:---:|:---:|:---:|:---:|
| ¼ | | 5400 | | | | 10800 | 48599 | 1 |
| 1/3 | | 7200 | | | | 14400 | 43199 | 1 |
| ½ | | | | 12960 | | 19440 | 32399 | 1 |
| 3/5 | | 12960 | | | | 25920 | 25919 | 1 |
| 2/3 | 4320 | | | | | 38880 | 21599 | 1 |
| ¾ | | 5400 | | | | 43200 | 16199 | 1 |
| 4/5 | | | 6480 | | | 45360 | 12959 | 1 |
| 5/6 | 5400 | | | | | 48600 | 10799 | 1 |
| 8/9 | | | | | 7200 | 50400 | 7199 | 1 |
| 9/10 | | | | | 6480 | 51840 | 6479 | 1 |

Some code designs, such as Intel's LDPC code proposed to 802.16, have only one **H** matrix and uses shortening to get other code rates, but the codes after shortening do not perform well. The portion of **H** corresponding to the information bits (denoted $H_1$) is regular (and therefore the entire matrix is sometimes referred to as semi-regular), and after shortening the code weight distribution is poor compared to a good design. Good LDPC designs tend not to have regular column weight in $H_1$.

Brief Description of the Drawings

FIG. 1 shows column weight distribution of a parity check matrix with non-interlaced column weight in $H_1$, i.e., the columns of the same weight are grouped together. The code size is (2000, 1600).
FIG. 2 shows column weight distribution of a parity check matrix with interlaced column weight in $H_1$. The code size is (2000, 1600).
FIG. 3 shows FER performance of un-shortened codes of size (2000, 1600).
FIG. 4 shows FER performance of the (1200, 800) codes shortened from the (2000, 1600) codes by 800 bits.
FIG. 5 shows FER performance of the (800, 400) codes shortened from the (2000, 1600) codes by 1200 bits.

Detailed Description of the Drawings

This invention proposes a method for constructing an irregular **H** matrix that performs well un-shortened or shortened, and using this matrix and its shortened versions for encoding. For a code that takes k information bits and generates n code bits, the **H** matrix is divided into two parts $H = [H_1 \ H_2]$, where $H_1$ has size m-by-k and $H_2$ has size m-by-m, m=n-k. $H_1$ corresponds to the un-shortened information bits, and $H_2$ corresponds to the parity bits, so that $[(H_1)_{m \times k} (H_2)_{m \times m}][(s)_{1 \times k} (p)_{1 \times m}]^T = 0,$. When shortening the first L positions of s, the first L columns of $H_1$ are essentially removed.
$H_1$ is deterministic in that a particular column weight structure is defined. $H_2$ is non-deterministic in that it can be regular or irregular, have any structure, or be randomly constructed. A preferred $H_2$ can be similar to the one described in US Pat. Application No. 10/839995 "Method And Apparatus For Encoding And Decoding Data" in the Intel 802.16 LDPC proposal (approximately lower triangular, all columns having weight 2 except last column having weight 1, 1's in a column are on top of each other, top 1 is on the diagonal. Mathematically the m-by-m $H_2$ matrix is described as the entry of row i column j being 1 if i=j, and i=j+1, 0<=i<=m-1, 0<=j<=m-1.)
One example of $H_2$ matrix is:

$$H_2 = \begin{bmatrix} h & \dot{H}'_2 \end{bmatrix}$$

$$= \begin{bmatrix} h_0 & 1 & & & & & & & \\ h_1 & 1 & 1 & & & & & & \\ \cdot & & 1 & 1 & & & \mathbf{0} & & \\ \cdot & & & 1 & 1 & & & & \\ \cdot & & & & 1 & 1 & & & \\ \cdot & & & & & 1 & 1 & & \\ \cdot & & & \mathbf{0} & & & 1 & 1 & \\ \cdot & & & & & & & 1 & 1 \\ \cdot & & & & & & & \ddots & \ddots \\ & & & & & & & & 1 & 1 \\ \cdot & & & & & & & & & 1 & 1 \\ h_{m-1} & & & & & & & & & & 1 \end{bmatrix}.$$

Where h is odd weight > 2, and may be h=[1 0 0 0 1 0 0 0 1 0 ... 0]$^T$.
Another exemplary realization of $H_2$ is

$$\mathbf{H}_2 = \begin{bmatrix} 1 & & & & & & & & & & \\ 1 & 1 & & & & & & & & & \\ & 1 & 1 & & & & & & \mathbf{0} & & \\ & & 1 & 1 & & & & & & & \\ & & & 1 & 1 & & & & & & \\ & & & & 1 & 1 & & & & & \\ & & & & & 1 & 1 & & & & \\ & \mathbf{0} & & & & & 1 & 1 & & & \\ & & & & & & & 1 & \ddots & & \\ & & & & & & & & \ddots & 1 & \\ & & & & & & & & & 1 & 1 \\ & & & & & & & & & & 1 & 1 \end{bmatrix}$$

For irregular codes that have better performance than regular codes, the columns of various weights can be arranged in any order without affecting performance, since permuting the order of code bits does not affect error-correcting performance. The column weights are therefore typically distributed with no particular order. For example, all columns of the same weight may be grouped together. When the leading L columns of **H** are effectively removed through shortening, the remaining weights can result in poor performance.

To solve the problem, the deterministic section $\mathbf{H}_1$ comprises a plurality of sub-matrices each having column weights substantially interlaced between the sub-matrices. Interlacing between sub-matrices is based on a desired column weight distribution for the sub-matrices. The interlacing between the sub-matrices is uniform if the desired column weight distribution is the same for all sub-matrices. The interlacing between the matrices is non-uniform if the desired column weight distribution is different for two sub-matrices. Within a sub-matrix, the columns of different weights may be interlaced such that the columns of different weight are spread predominantly uniformly over the sub-matrix.

In this invention, the columns of different weights are uniformly or non-uniformly interlaced between sub-matrices, so that the resulting shortened matrix can have much better weight distribution, and therefore better error-correcting performance. Let $\mathbf{H}_1$ be irregular in that it has two or more distinct columns weights (e.g., 3 and 10 ones in each column of $\mathbf{H}_1$). The columns of $\mathbf{H}_1$ are further divided into two sections (sub-matrices), $\mathbf{H}_{1a}$ and $\mathbf{H}_{1b}$, where $\mathbf{H}_{1a}$ is an m-by-L matrix (i.e., first L columns of $\mathbf{H}_1$) and $\mathbf{H}_{1b}$ is an $m$-by-$(k\text{-}L)$ matrix (i.e., remaining $k$-L columns of $\mathbf{H}_1$). The columns of different weights are interlaced between $\mathbf{H}_{1a}$ and $\mathbf{H}_{1b}$, so that after shortening L bits (i.e., effectively removing $\mathbf{H}_{1a}$ from **H**); the resulting code with $[\mathbf{H}_{1b}\ \mathbf{H}_2]$ has a good weight distribution.

When encoding, the encoder first prepends L zeros to the current symbol set of length (k-L). Then the zero-padded information vector $\mathbf{s}=[\mathbf{0}_L\ \mathbf{s}_b]$, where $\mathbf{s}_b$ has length $k$-L, is encoded using **H** as if un-shortened to generate parity bit vector **p** (length $m$). After removing the prepended zeros from the current symbol set, the code bit vector $\mathbf{x}=[\mathbf{s}_b\ \mathbf{p}]$ is transmitted over the channel. This encoding procedure is equivalent to encoding the information vector $\mathbf{s}_b$ using the shortened matrix $[\mathbf{H}_{1b}\ \mathbf{H}_2]$ to determine the parity-check bits.

The simple example was described with two regions of $\mathbf{H}_1$, but $\mathbf{H}_1$ can be further subdivided with the columns interlaced over smaller regions. The column weight interlacing is performed such that after shortening the resulting parity check matrices all have a good weight distribution.

The interlacing between sub-matrices may be performed in a uniform or non-uniform manner. Uniform interlacing has a desired weight distribution that preserves the approximate column weight ratio of $\mathbf{H}_1$ for each region of $\mathbf{H}_1$. For example, if $\mathbf{H}_1$ has approximately 25% weight x1 and 75% weight x2 columns, $\mathbf{H}_{1a}$ and $\mathbf{H}_{1b}$ can each have approximately 25% weight x1 and 75% weight x2 columns by interlacing one weight x1 column with three weight x2 columns throughout $\mathbf{H}_1$. Alternatively, the columns can be arranged by placing approximately round(0.25*width($\mathbf{H}_{1a}$)) weight x1 column followed by round(0.75*width($\mathbf{H}_{1a}$) weight x2 columns in $\mathbf{H}_{1a}$. In both cases $\mathbf{H}_{1b}$ will have a column weight distribution as $\mathbf{H}_{1a}$, and the arrangement of the columns in $\mathbf{H}_{1b}$ does not affect performance unless the code is further shortened (i.e., $\mathbf{H}_{1b}$ is divided into additional regions). Uniform interlacing generally results in sub-optimal weight distributions for the shortened codes.

Non-uniform interlacing attempts to match a desired weight distribution for each region of $\mathbf{H}_1$. For example, if $\mathbf{H}_1$ has a weight distribution of 25% weight x1 and 75% weight x2, but a 50% shortened code with $\mathbf{H}_{1b}$ has a desired weight distribution of 50% weight x1 and 50% weight x2, $\mathbf{H}_{1b}$ can achieve the desired distribution by non-uniform interlacing of the columns between $\mathbf{H}_{1a}$ and $\mathbf{H}_{1b}$. In this case, approximately round(0.25*width($\mathbf{H}_1$) - 0.5*width($\mathbf{H}_{1b}$)) weight x1 columns and approximately round(0.75*width($H_1$) - 0.5*width($H_{1b}$) weight x2 columns are placed in $H_{1a}$, and $H_{1b}$ has the desired weight distribution of 0.5*width($H_{1b}$) weight x1 and 0.5*width($H_{1b}$) weight x2 columns. An interlaced non-uniform distribution is achieved by interlacing approximately one weight x2 column with zero weight x1 columns in $H_{1a}$ (i.e., all of $H_{1a}$ are weight x2 columns) and (if desired) by alternating approximately one weight x2 column with one weight x1 column in $H_{1b}$. If multiple shortened code rates are to be supported, then the non-uniform interlacing with columns of various weight scattered over the sub-matrix is desirable in providing better performance for all shortened code rates.

### Algorithm Pseudo code

[The following Matlab is included to illustrate how a good column weight distribution may be found for a given code rate and code size using the desired weight distributions.

```
% get optimized degree distribution, dv = maximum column weight, rate is code rate
vDeg = getDegDist(rate, dv);
% get the number of variable nodes of each weight, N is the number of columns in H
vNodes = round(N * vDeg(2,:)./vDeg(1,:)/sum(vDeg(2,:)./vDeg(1,:)));

function [vDeg] = getDegDist(rate, dv)
% vDeg(1,i): col weight i
% vDeg(2,i): fraction of edges linked to variable node of weight vDeg(1,i)
% vDeg(3,i): fraction of variable nodes of weight vDeg(1,i)

if (abs(rate -1/2)<1e-4)
    if (dv == 4)
        vDeg = [2 3 4;
                0.38354 0.04237 0.57409
                0.54883 0.04042 0.41075];
    elseif (dv == 11)
        vDeg = [2 3 5 6 11
         0.288212 0.256895 0.0285565 0.15190 0.274437
         0.50437 0.29971 0.01999 0.088608 0.087321];
    end
    elseif (abs(rate-2/3)<1e-4)
    if (dv == 10)
        vDeg = [2 0.1666670000 (0.33000059795989)
                3 0.3679650000 (0.48571370868582)
                 10 0.4653680000 (0.18428569335429)]';
    end
    elseif (abs(rate-4/5)<1e-4)
    if (dv == 10)
        vDeg = [2 0.1000000000 (0.19999992000003)
                    3 0.4714290000 (0.6285717485713)
                     10 0.4285710000 (0.17142833142867)]';
    end
    end
```

The following Matlab code illustrates how to interlace within a submatrix. Note that s is the vector of column weights, and z1 and z2 are dependent on the particular column weight distribution within the submatrix.

```
temp = [s(1:length1) -ones(1,total_length-length1)];
submatrix1 = reshape(reshape(temp, z1, z2)', 1, z1*z2);
idx = find(submatrix1<0);
submatrix1(idx) = [];
```

### Example

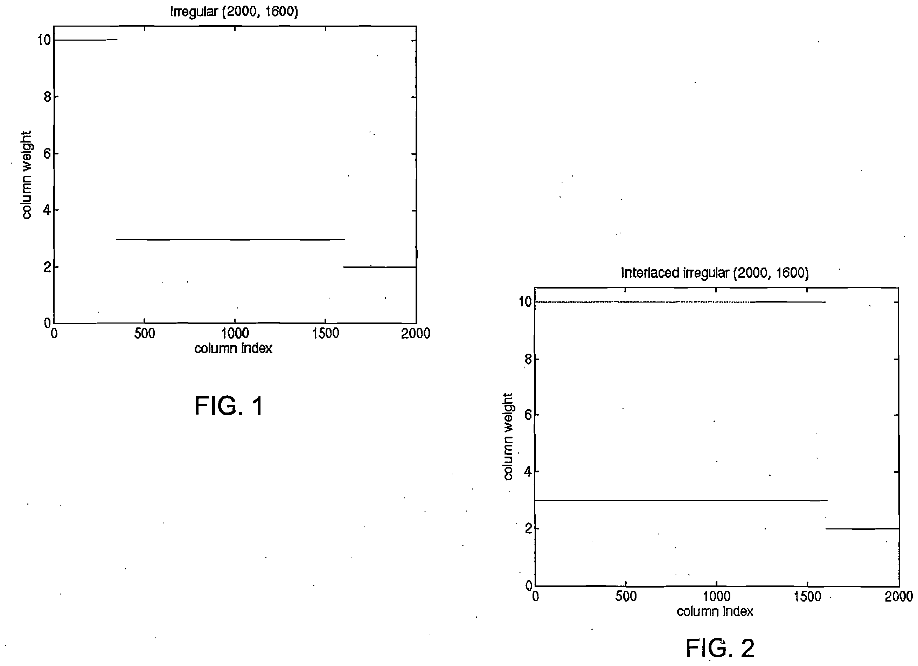

An example is used to illustrate the proposal described above. For a rate 4/5 code of size (2000, 1600), an **H** matrix is found with column weights of 2, 3, and 10. The column weight distribution of the un-interlaced parity-check matrix $H_{non}$ is plotted in Figure 1. After column interlacing of the $H_1$ portion, the column weight distribution of the resulting parity-check matrix $H_{inter}$ is plotted in Figure 2, and listed in Appendix A. Matrix $H_{inter}$ is the same as matrix $H_{non}$ except that the column permutation is introduced.

When shortening $\mathbf{H}_{inter}$, the resulting matrix still maintains good column weight distributions. As an example, given target weight distributions of a rate 2/3 code,

vDeg = [2 0.1666670000 (0.33000059795989)
3 0.3679650000 (0.48571370868582)
10 0.4653680000 (0.18428569335429)];

where the first column indicates desired column weight, the third column indicates the number of columns with the given weight, the non-uniform insertion algorithm yields the column weight distributions of derived rate 2/3 code in Table 2. Similar procedure is used to find the desired column weight distribution of the rate ½ code (after shortening the original rate 4/5 code) in Table 2. The weight distributions for $\mathbf{H}_{non}$ and $\mathbf{H}_{u\_inter}$ (with uniform interlacing) are given in Tables 3 and 4, respectively. Note that in all cases $\mathbf{H}_2$ has 399 weight 2 and one weight 3 columns, and $\mathbf{H}_1$ has one weight 2 column.

**Table 2. Number of Columns of Various Weight in rate 4/5 $\mathbf{H}_{inter}$ and its derived codes.**

| Code Rate | 10 | 3 | 2 |
|---|---|---|---|
| ½ | 191 | 217 | 400 |
| 2/3 | 221 | 583 | 400 |
| 4/5 | 343 | 1257 | 400 |

**Table 3. Number of Columns of Various Weight in rate 4/5 $\mathbf{H}_{non}$ codes.**

| Code Rate | 10 | 3 | 2 |
|---|---|---|---|
| ½ | 0 | 400 | 400 |
| 2/3 | 0 | 800 | 400 |
| 4/5 | 343 | 1257 | 400 |

**Table 4. Number of Columns of Various Weight in rate 4/5 $\mathbf{H}_{u\_nter}$ and its derived codes.**

| Code Rate | 10 | 3 | 2 |
|---|---|---|---|
| ½ | 84 | 316 | 400 |
| 2/3 | 168 | 632 | 400 |
| 4/5 | 343 | 1257 | 400 |

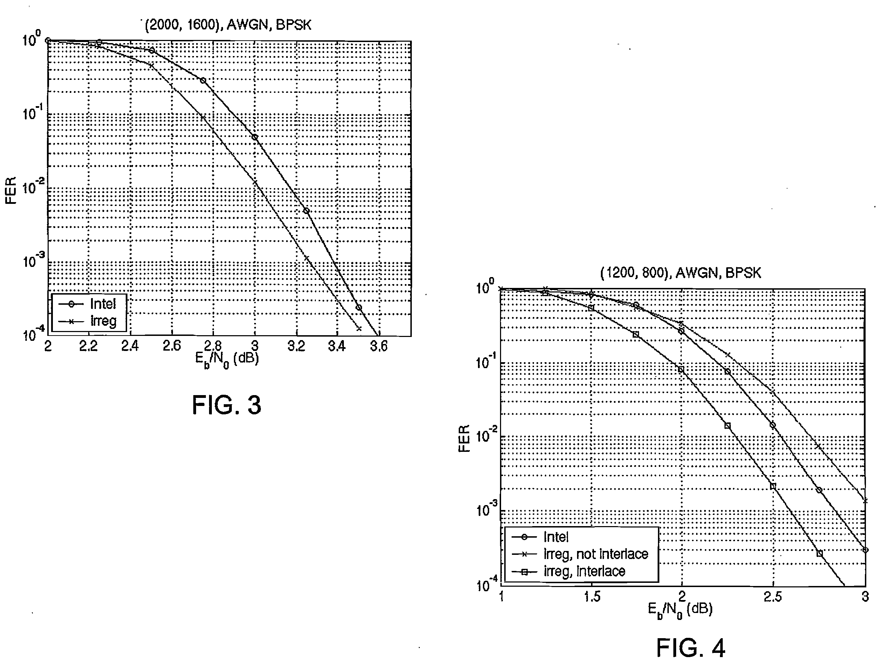

Simulations studies show that non-uniform interlacing yields LDPC codes with good performance un-shortened or shortened. The performance of the un-shortened rate 4/5 code is shown in Figure 3, in comparison to the 802.16 proposed code design. Note that without shortening, the irregular code design has the same performance with or without column weight interlacing. Simulation shows that $\mathbf{H}_{non}$ and $\mathbf{H}_{inter}$ perform 0.2 dB better than the 802.16 proposed design (Intel) at FER=$10^{-2}$.

When shortening the code by L=800 information positions, the leading 800 columns of $\mathbf{H}_{non}$ (or $\mathbf{H}_{inter}$) are essentially removed, resulting in a rate 2/3 code. The performance of the shortened codes is shown in Figure 4, in comparison to the similarly shortened 802.16 proposed design. The simulation shows that without interlacing, the code performance after shortening is inferior to the 802.16 proposed design (Intel) due to the poor weight distribution after shortening. However, after interlacing, the code performance is 0.25 dB better than the 802.16 proposed design at FER=$10^{-2}$.

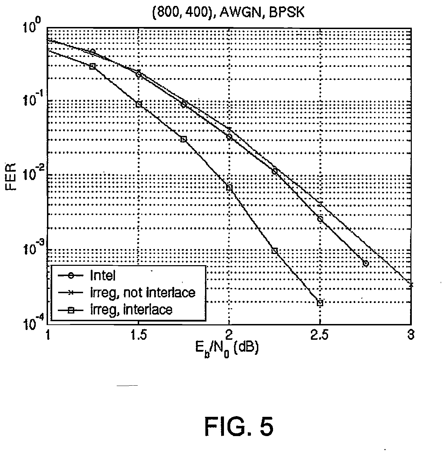

Similarly, the code can be further shortened. When shortening the original code by L=1200 information positions, the leading 1200 columns of $\mathbf{H}_{non}$ (or $\mathbf{H}_{inter}$) are essentially removed, resulting in a rate ½ code. The performance of the shortened codes is shown in Figure 5, in comparison to the similarly shortened 802.16 proposed design. The simulation shows that without interlacing, the code performance after shortening is slightly inferior to the 802.16 proposed design due to the poor weight distribution after shortening. However, after interlacing, the code performance is 0.35 dB better than the 802.16 proposed design at FER=$10^{-2}$.

Figure 1 shows column weight distribution of the parity check matrix with non-interlaced column weight in $\mathbf{H}_1$,

i.e., the columns of the same weight is grouped together. The code size is (2000, 1600).

Figure 2 shows column weight distribution of the parity check matrix with interlaced column weight in $H_1$. The code size is (2000, 1600).

Figure 3 shows FER performance of the un-shortened codes of size (2000, 1600). The two un-shortened codes are: (a). 802.16 proposed design (Intel); (b). The irregular code design. Note that without shortening, the irregular code design has the same performance with or without column weight interlacing.

Figure 4 shows FER performance of the (1200, 800) codes shortened from the (2000, 1600) codes by 800 bits. The three un-shortened codes are: (a). 802.16 proposed design (Intel); (b). The irregular code design without column weight interlacing; (c). the irregular code design with the column weight interlacing.

Figure 5 shows FER performance of the (800, 400) codes shortened from the (2000, 1600) codes by 1200 bits. The three un-shortened codes are: (a). 802.16 proposed design (Intel); (b). the irregular code design without column weight interlacing; (c). the irregular code design with the column weight interlacing.

Appendix: Interlaced Column Weight Distribution

Presented below is the column weight distribution of the irregular (2000, 1600) **H** matrix after interlacing the $H_1$ section. The column weight of each column are shown starting from the first column.

10 3 3 3 3 3 10 3 3 3 3 3 10 3 3 3 3 3 10 3 3 3 3 3 10 3 3 3 3 3 10 3 3 3 3 3 10 3 3 3 3 3 10 3 3 3 3 3 10
3 3 3 3 3 10 3 3 3 3 3 10 3 3 3 3 3 10 3 3 3 3 3 10 3 3 3 3 3 10 3 3 3 3 3 10 3 3 3 3 3 10 3 3 3 3 3 10 3
3 3 3 3 10 3 3 3 3 3 10 3 3 3 3 3 10 3 3 3 3 3 10 3 3 3 3 3 10 3 3 3 3 3 10 3 3 3 3 3 10 3 3 3 3 3 10 3 3
3 3 3 10 3 3 3 3 3 10 3 3 3 3 3 10 3 3 3 3 3 10 3 3 3 3 3 10 3 3 3 3 3 10 3 3 3 3 3 10 3 3 3 3 3 10 3 3 3
3 3 10 3 3 3 3 3 10 3 3 3 3 3 10 3 3 3 3 3 10 3 3 3 3 3 10 3 3 3 3 3 10 3 3 3 3 3 10 3 3 3 3 3 10 3 3 3 3
3 10 3 3 3 3 3 10 3 3 3 3 3 10 3 3 3 3 3 10 3 3 3 3 3 10 3 3 3 3 3 10 3 3 3 3 3 10 3 3 3 3 3 10 3 3 3 3 3
10 3 3 3 3 3 10 3 3 3 3 3 10 3 3 3 3 3 10 3 3 3 3 3 10 3 3 3 3 3 10 3 3 3 3 3 10 3 3 3 3 3 10 3 3 3 3 3 10 3
3 3 3 10 3 3 3 3 3 10 3 3 3 3 3 10 3 3 3 3 3 10 3 3 3 3 3 10 3 3 3 3 3 10 3 3 3 3 3 10 3 3 3 3 3 10 3 3 3 3
3 10 3 3 3 3 3 10 3 3 3 3 3 10 3 3 3 3 3 10 3 3 3 3 3 10 3 3 3 3 3 10 3 3 3 3 3 10 3 3 3 3 3 10 3 3 3 3 3
10 3 3 3 3 3 10 3 3 3 3 3 10 3 3 3 3 3 10 3 3 3 3 3 10 3 3 3 3 3 10 3 3 3 3 3 10 3 3 3 3 3 10 3 3 3 3 3 10 3
3 3 3 10 3 3 3 3 3 10 3 3 3 3 3 10 3 3 3 3 3 10 3 3 3 3 3 10 3 3 3 3 3 10 3 3 3 3 3 10 3 3 3 3 3 10 3 3 3 3
3 10 3 3 3 3 3 10 3 3 3 3 3 10 3 3 3 3 3 10 3 3 3 3 3 10 3 3 3 3 3 10 3 3 3 3 3 10 3 3 3 3 3 10 3 3 3 3 3 10
3 3 3 3 3 10 3 3 3 3 3 3 3 3 3 3 3 10 3 3 3 3 3 3 3 3 3 3 3 10 3 3 3 3 3 3 3 3 3 3 3 10 3 3 3 3 3 3 3 3 3 3 3 10
3 3 3 3 3 3 3 3 3 3 3 10 3 3 3 3 3 3 3 3 3 3 3 10 3 3 3 3 3 3 3 3 3 3 3 10 3 3 3 3 3 3 3 3 3 3 3 10 3 3 3 3 3 3 3
3 3 3 3 3 3 10 3 3 3 3 3 3 3 3 3 3 3 10 3 3 3 3 3 3 3 3 3 3 3 10 3 3 3 3 3 3 3 3 3 3 3 10 3 3 3 3 3 3 3 3 3 3 3 10
3 3 3 3 3 3 3 3 3 3 10 3 3 3 3 3 3 3 3 3 3 3 10 3 3 3 3 3 3 3 3 3 3 3 10 3 3 3 3 3 3 3 3 3 3 3 10 3 3 3 3 3 3 3 3 3
3 3 3 10 3 3 3 3 3 3 3 3 3 3 3 10 3 3 3 3 3 3 3 3 3 3 3 10 3 3 3 3 3 3 3 3 3 3 3 10 3 3 3 3 3 3 3 3 3 3 3 10 3 3
3 3 3 3 3 3 3 3 3 10 3 3 3 3 3 3 3 3 3 3 3 10 3 3 3 3 3 3 3 3 3 3 3 10 3 3 3 3 3 3 3 3 3 3 3 10 3 3 10 3 3 10 3 3 10 3 3
10 3 3 10 3 3 10 3 3 10 3 3 10 3 3 10 3 3 10 3 3 10 3 3 10 3 3 10 3 3 10 3 3 10 3 3 10 3 3 10 3 3 10 3 3 10 3 3 10 3 3 10 3 3
10 3 3 10 3 3 10 3 3 10 3 2 10 3 10 3 10 3 10 3 10 3 10 3 10 3 10 3 10 3 10 3 10 3 10 3 10 3 10 3 10 3 10 3 10 3 10 3 10 3
10 3 10 3 10 3 10 3 10 3 10 3 10 3 10 3 10 3 10 3 10 3 10 3 10 3 10 3 10 3 10 3 10 3 10 3 10 3 10 3 10 3 10 3 10 3 10 3 10
3 10 3 10 3 10 3 10 3 10 3 10 3 10 3 10 3 10 3 10 3 10 3 10 3 10 3 10 3 10 3 10 3 10 3 10 3 10 3 10 3 10 3 10 3 10 3 10 3
10 3 10 3 10 3 10 3 10 3 10 3 10 3 10 3 10 3 10 3 10 3 10 3 10 3 10 3 10 3 10 3 10 3 10 3 10 3 10 3 10 3 10 3 10 3 10 3 10
3 10 3 10 3 10 3 10 3 10 3 10 3 10 3 10 3 10 3 10 3 10 3 10 3 10 3 10 3 10 3 10 3 10 3 10 3 10 3 10 3 10 3 10 3 10 3 10 3
10 3 10 3 10 3 10 3 10 3 10 3 10 3 10 3 10 3 10 3 10 3 10 3 10 3 10 3 10 3 10 3 10 3 10 3 10 3 10 3 10 3 10 3 10 3 10 3 10
3 10 3 10 3 10 3 10 3 10 3 10 3 10 3 10 3 10 3 10 3 10 3 10 3 10 3 10 3 10 3 10 3 10 3 10 3 10 3 10 3 10 3 10 3 10 3 10 3
10 3 10 3 10 3 10 3 10 3 10 3 3 2 2 2 2 2 2 2 2 2 2 2 2 2 2 2 2 2 2 2 2 2 2 2 2 2 2 2 2 2 2 2 2 2 2 2 2 2 2 2 2 2
2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2
2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2
2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2
2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2
2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2
2 2 2 2 2 2 2 2 2 2 2 2 2 2 2 2 2 2 2 2 2 2 2 2 2 2 2 2 2 2 2 2 2 2 2

**Claims**

**1.** A method for encoding that generates parity-check bits $(p_0, ..., p_{m-1})$ based on a current symbol set $s=(s_0, ..., s_{k-L-1})$,

the method comprising the steps of:

acquiring a value L;

obtaining the current symbol set s=($s_0$, ..., $s_{k-L-1}$) of length (k-L);

obtaining a zero-padded information vector **s** of length k by zero padding the current symbol set with L zeroes where L>0;

using a matrix **H** and the zero-padded information vector **s** to determine the parity-check bits, wherein **H** comprises a section $\mathbf{H_1}$ and a section $\mathbf{H_2}$ and $\mathbf{H_1}$ has size m-by-k and $\mathbf{H_2}$ has size m-by-m; and

transmitting the parity-check bits along with the current symbol set **s**=($s_0$, ..., $s_{k-L-1}$);

**characterised in that** $\mathbf{H_1}$ consists of two sub-matrices $\mathbf{H_{1a}}$ of dimension m-by-L , and $H_{1b}$ is of dimension m-by-(k-L) and wherein two column weights exist in $\mathbf{H_{1a}}$ and $\mathbf{H_{1b}}$, and $\mathbf{H_{1a}}$ has a column weight distribution consisting of round (0.25 * L) number of columns of a first weight and round(0.75*L) number of columns of a second weight, the first column weight being different from the second column weight, and non-uniform interlacing of the columns between $H_{1a}$ and $H_{1b}$ is implemented.

## Patentansprüche

1. Verfahren zum Codieren, das Paritätsprüfbits ($p_0$ $p_{m-1}$) basierend auf einem aktuellen Symbolsatz **s** =($s_0$, ... $s_{k-L-1}$) erzeugt, das Verfahren die Schritte umfassend:

Akquirieren eines Werts L;

Erhalten des aktuellen Symbolsatzes **s** ={$s_0$,..., $s_{k,-L-1}$) der Länge (k-L);

Erhalten eines mit Nullen aufgefüllten Informationsvektors s der Länge k durch Auffüllen des aktuellen Symbolsatzes mit L Nullen, wobei L>0;

Verwenden einer Matrix **H** und des mit Nullen aufgefüllten Informationsvektors s zum Bestimmen der Paritätsprüfbits, wobei **H** einen Abschnitt $\mathbf{H_1}$ und einen Abschnitt $\mathbf{H_2}$ umfasst und $\mathbf{H_1}$ die Größe m x k und $\mathbf{H_2}$ die Größe m x m aufweist; und

Übertragen der Paritätsprüfbits zusammen mit dem aktuellen Symbolsatz **s**= ($S_0$, ... $S_{k-L-1}$);

**dadurch gekennzeichnet, dass** $\mathbf{H_1}$ aus zwei Teilmatrizen, $\mathbf{H_{1a}}$ mit der Größe m x L, und $\mathbf{H_{1b}}$ mit der Größe m x (k-L), besteht, wobei zwei Spaltengewichtungen in $\mathbf{H_{1a}}$ und $\mathbf{H_{1b}}$ vorhanden sind und $\mathbf{H_{1a}}$ eine Spaltengewichtungsverteilung aufweist, die aus einer runden (0,25* L) Anzahl an Spalten einer ersten Gewichtung und einer runden (0,75* L) Anzahl an Spalten einer zweiten Gewichtung besteht, wobei sich die erste Spaltengewichtung von der zweiten Spaltengewichtung unterscheidet und eine nicht gleichmäßige Verschachtelung der Spalten zwischen $\mathbf{H_{1a}}$ und $\mathbf{H_{1b}}$ implementiert ist.

## Revendications

1. Procédé d'encodage qui génère des bits de contrôle de parité ($p_0$, ..., $p_{m-1}$) sur la base d'un ensemble de symboles actuel **s**=($s_0$, ... $s_{k-L-1}$), le procédé comprenant les étapes :

d'acquisition d'une valeur L ;

d'obtention de l'ensemble de symboles actuel **s**={$s_0$, ..., $s_{k-L-1}$) de longueur (k-L) ;

d'obtention d'un vecteur d'information à remplissage de zéros s de longueur k par un remplissage de zéros de l'ensemble de symboles actuel avec L zéros, où L > 0 ;

d'utilisation d'une matrice **H** et du vecteur d'information à remplissage de zéros s pour déterminer les bits de contrôle de parité, où **H** comprend une section $\mathbf{H_1}$ et une section $\mathbf{H_2}$ et $\mathbf{H_1}$ a une taille m-par-k et $\mathbf{H_2}$ a une taille m-par-m ; et

de transmission des bits de contrôle de parité avec l'ensemble de symboles actuel **s**=($S_0$, ... $S_{k-L-1}$) ;

**caractérisé en ce que** $\mathbf{H_1}$ est constitué de deux sous-matrices $\mathbf{H_{1a}}$ de dimension m-par-L, et $\mathbf{H_{1b}}$ est de dimension m-par-(k-L) et dans lequel deux poids de colonnes existent dans $\mathbf{H_{1a}}$ et $\mathbf{H_{1b}}$, et $\mathbf{H_{1a}}$ a une distribution de poids de colonnes constituée d'un (0,25*L) chiffre rond de colonnes d'un premier poids et d'un (0,75*L) chiffre rond de colonnes d'un deuxième poids, le poids de la première colonne étant différent du poids de la deuxième colonne, et un entrelacement non uniforme des colonnes entre $\mathbf{H_{1a}}$ et $\mathbf{H_{1b}}$ est mis en oeuvre.

FIG. 1

FIG. 2

(2000, 1600), AWGN, BPSK

**FIG. 3**

(1200, 800), AWGN, BPSK

**FIG. 4**

FIG. 5

EP 2 405 581 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 10839995 B